# EUROPÄISCHE PATENTSCHRIFT

(11) **EP 1 362 391 B1**
(45) Veröffentlichungstag und Bekanntmachung des Hinweises auf die Patenterteilung: **20.12.2006**
(21) Anmeldenummer: 02702225.0
(22) Anmeldetag: 31.01.2002
(51) Int. Cl.: H01R 11/24

(54) **ANSCHLUSSKLEMME**
TERMINAL CONNECTOR
BORNE DE RACCORDEMENT

(30) Priorität: 02.02.2001 DE 10104633
(43) Veröffentlichungstag der Anmeldung: 19.11.2003
(73) Patentinhaber: ROBERT BOSCH GMBH, 70442 Stuttgart (DE)
(72) Erfinder: KUTTERUF, Karl-Martin, 73272 Neidlingen (DE)
(74) Vertreter: Gleiss & Grosse
(86) Internationale Anmeldenummer: PCT/DE2002/000344
(87) Internationale Veröffentlichungsnummer: WO 2002/061885

(56) Entgegenhaltungen:
- FR-A- 936 469
- PATENT ABSTRACTS OF JAPAN vol. 005, no. 060 (P-058), 23. April 1981 (1981-04-23) & JP 56 014160 A (TOSHIBA CORP), 10. Februar 1981 (1981-02-10)

## Beschreibung

Die vorliegende Erfindung betrifft eine Anschlussklemmensystem, insbesondere eine Anschlussklemmensystem für ein Batterietestgerät, nach dem Oberbegriff des Anspruchs 1.

### Stand der Technik

Die gattungsgemäßen Anschlussklemmensysteme mit Anschlussklemme und Leitungen werden beispielsweise im Zusammenhang mit Batterietestgeräten eingesetzt. Zum Testen einer Batterie, beispielsweise einer Autobatterie, ist es erforderlich, die Pole beziehungsweise die Kontakte der Batterie sowohl mit einer Last als auch mit einem Messgerät zu verbinden, und zwar durch getrennte Leitungen. Bei bekannter Last kann dann beispielsweise durch eine Spannungs- und Strommessung der Innenwiderstand der Batterie bestimmt werden, der ein Maß für die Startleistung darstellt; die die Batterie abgeben kann. Bei den bekannten Anschlussklemmen sind beide Klemmenhälften elektrisch leitend verbunden und bilden einen Lastanschluss. Dabei ist innerhalb einer Klemmenhälfte ein bezüglich dieser Klemmenhälfte elektrisch isolierter Kontaktbereich für den Messanschluss vorgesehen. Bei den bekannten Ausführungsformen der gattungsgemäßen Anschlussklemme ist der Öffnungswinkel gegenüber einer Standardklemme ohne Messanschluss eingeschränkt. Der Messanschluss ist schwierig anzuschließen und häufig aufwendig in die entsprechende Klemmenhälfte eingeklebt oder eingeschweißt. Bei der Verwendung der Anschlussklemme tritt in vielen Fällen das Problem auf, dass nicht sichergestellt werden kann, dass nur der Kontaktbereich für den Messanschluss kontaktiert, nicht jedoch die.Klemmenhälfte in der er untergebracht ist. Weiterhin besteht das Problem, dass der Messanschluss beziehungsweise der entsprechende Kontaktbereich sich bei bestimmten Belastungsfällen oder durch Vibration lösen kann.

Aus der FR-A-936469 ist eine Anschlussklemme mit zwei über ein Gelenk verbundenen Griffhälften bekannt, die jeweils einen Kunststoffgriff mit darin elektrisch isoliert eingeformten Kontaktbereichen aufweisen. Zur Bildung des Gelenks sind in die Kunststoffgriffe Blechteile eingebettet, die mittels einer Achse zueinander verschwenkt werden können und zwischen sich eine Spiralfeder zum Aufbau einer Kontaktkraft aufweisen. Für einen Leistungsanschluß sind die Kunststoffteile mit Längskanälen versehen, die bis zu den Kontaktteilen vorlaufen. Die bekannte Anschlußklemne ist mechanisch wenig belastbar, da im Bereich des Gelenks sowohl die Konktaktbereiche als auch die Blechteile in die Kunststoffgriffe eingebettet sind, sodaß eine Dünnwandigkeit vorliegt.

Die Erfindung liegt daher die Aufgabe zugrunde, ein Anschlussklemmensystem anzugeben, dass mechanish stabil und elektrisch zuverlässig ist und auch einfach gehandhabt werden kann.

Diese Aufgabe wird durch ein erfindungsgemäßes Anschlussklemmensystem gelöst. Die erste Klemmenhälfte weist nur einen ersten Kontaktbereich auf, der ausschließlich zur Herstellung der Verbindung zwischen dem Kontakt und der ersten Leitung vorgesehen ist, dass die zweite Klemmenhälfte nur einen zweiten Kontaktbereich aufweist, der ausschließlich zur Herstellung der Verbindung zwischen dem Kontakt und der zweiten Leitung vorgesehen ist, und dass der erste Kontaktbereich und der zweite Kontaktbereich elektrisch voneinander isoliert sind, kann sichergestellt werden, dass sowohl die erste Leitung als auch die zweite Leitung sicher mit einem Kontakt, beispielsweise einem Batteriepol, elektrisch verbunden werden kann.

Die erste Klemmenhälfte weist zumindest einen aus elektrisch leitfähigem Material hergestellten ersten Abschnitt auf, der den ersten Kontaktbereich bildet. In diesem Fall kann auf eine Verbindung, beispielsweise eine Klebeverbindung, zwischen der ersten Klemmenhälfte und dem ersten Kontaktbereich verzichtet werden, was vorteilhaft ist, weil sich insbesondere Klebeverbindungen beim Stand der Technik häufig ungewollt gelöst haben.

Aus dem gleichen Grund ist bei der erfindungsgemäßen Anschlussklemme vorgesehen, dass die zweite Klemmenhälfte zumindest einen aus elektrisch leitfähigem Material hergestellten zweiten Abschnitt aufweist, der den zweiten Kontaktbereich bildet.

Die erste Klemmenhälfte und die zweite Klemmenhälfte sind durch ein Gelenk miteinander verbunden wobei sich der erste Abschnitt nicht bis zu dem Gelenk erstreckt. In diesem Fall bleiben der erste Abschnitt und der zweite Abschnitt voneinander elektrisch isoliert, auch wenn das Gelenk und/oder die mit dem Gelenk in Verbindung stehenden Abschnitte der Klemmenhälften aus elektrisch leitendem Material gebildet sind. In diesem Zusammenhang ist es beispielsweise denkbar, einen jeweiligen Endabschnitt der ersten Klemmenhälfte und der zweiten Klemmenhälfte derart aus einem Kunststoffmaterial herzustellen, dass sich das Gelenk im Bereich dieses Kunststoffmaterials befindet und dass die. Kunststoffabschnitte als Griffe dienen.

Die erste Leitung und die zweite Leitung sind hinter der Klemme durch Verbindungsmittel elektrisch isoliert verbunden. Eine derartige Ausführungsform verhindert es, dass sich die erfindungsgemäße Anschlussklemme beim Herausziehen zwischen mehreren Kabeln verhakt, da sich die erste Leitung und die zweite Leitung und somit die gesamte Anschlussklemme, zumindest bei einer Zugbelastung keilförmig zwischen den anderen Kabeln hindurchbewegt. Ohne darauf beschränkt zu sein, kommen als Verbindungsmittel beispielsweise ein oder mehrere Kunststoffririge beziehungsweise -hülsen in Betracht, die über die erste Leitung und die zweite Leitung geschoben eine Art Presssitz bilden. Die erste Leitung ist an dem einen ersten Griff bildenden Endabschnitt der ersten Klemmenhälfte herausgeführt und die zweite Leitung ist an dem einen zweiten Griff bildenden Endabschnitt der zweiten Klemmenhälfte herausgeführt. Dieses Herausführen der ersten Leitung und der zweiten Leitung erfolgt dabei derart, dass ein Verhaken mit anderen Kabeln zumindest weitgehend ausgeschlossen wird.

Bei der erfindungsgemäßen Anschlussklemme ist vorzugsweise weiterhin vorgesehen, dass die Ader der ersten Leitung an einem ersten Verbindungspunkt an den ersten Abschnitt angeschweißt ist, und dass die Ader der zweiten Leitung an einem zweiten Verbindungspunkt an den zweiten Abschnitt angeschweißt ist. Eine Schweißverbindung ergibt sowohl einen sehr geringen Übergangswiderstand als auch eine gute Stabilität. Dennoch können gegebenenfalls auch andere Verbindungsformen eingesetzt werden, beispielsweise Schraub- oder Lötverbindungen.

Vorzugsweise ist im Zusammenhang mit der erfindungsgemäßen Anschlussklemme vorgesehen, dass die erste Leitung zum Anschluss einer Last vorgesehen ist. Bei einer derartigen Last kann es sich beispielsweise um eine Eingangs erwähnte Last handeln, die zur Bestimmung des Innenwiderstands einer Batterie angeschlossen wird.

Im Zusammenhang mit der erfindungsgemäßen Anschlussklemme ist vorzugsweise weiterhin vorgesehen, dass die zweite Leitung zur Durchführung einer Strom- und/oder Spannungsmessung vorgesehen ist. Dies gilt insbesondere wenn die erste Leitung zum Anschluss einer Last vorgesehen ist und die erfindungsgemäße Anschlussklemme mit einem Batterietestgerät verwendet werden soll.

Die erfindungsgemäße Anschlussklemme weist vorzugsweise weiterhin Vorspannmittel auf, die den ersten Kontaktbereich und den zweiten Kontaktbereich aufeinander zu vorspannen, wie dies an sich bekannt ist.

Bei der erfindungsgemäßen Anschlusskleinme kann weiterhin vorgesehen sein, dass das Gelenk ein Drehgelenk ist, das einen Bolzen umfasst, um den die erste Klemmenhälfte und/oder die zweiten Klemmenhälfte schwenkbar sind. Das Gelenk kann dann beispielsweise durch den erwähnten Bolzen und entsprechende Bohrungen in den Klemmenhälften gebildet sein.

Bei der erfindungsgemäßen Anschlussklemme ist vorzugsweise vorgesehen, dass die Vorspannmittel im Bereich des Gelenks angeordnet sind.

Insbesondere in diesem Zusammenhang -kann bei der erfindungsgemäßen Anschlussklemme weiterhin vorgesehen sein, dass die Vorspannmittel durch eine Spiralfeder gebildet sind, die zumindest abschnittsweise um den Bolzen herum angeordnet ist.

Bei bestimmten Ausführungsformen der erfindungsgemäßen Anschlussklemme ist vorgesehen, dass die Vorspannmittel ein erstes freies Ende und ein zweites freies Ende aufweisen, und dass sich das erste freie Ende an der ersten Klemmenhälfte abstützt, während sich das zweite freie Ende an der zweiten Klemmenhälfte abstützt. Eine derartige Ausführungsform kommt insbesondere dann in Betracht, wenn die Vorspannmittel durch eine Spiralfeder gebildet sind, insbesondere eine Spiralfeder, durch die sich ein Bolzen erstreckt, der Bestandteil des Gelenks ist. In diesem Fall wird die Federkraft über das erste freie Ende und das zweite freie Ende der Spiralfeder vorzugsweise derart auf die erste Klemmenhälfte und die zweite Klemmenhälfte übertragen, dass der erste Kontaktbereich und der zweite Kontaktbereich aufeinander zu vorgespannt werden.

Jede Verwendung eines erfindungsgemäßen Anschlussklemmensystems mit einem Batterietestgerät fällt in den Schutzbereich der zugehörigen Ansprüche.

Die Erfindung wird nachfolgend näher erläutert.

Es zeigt:

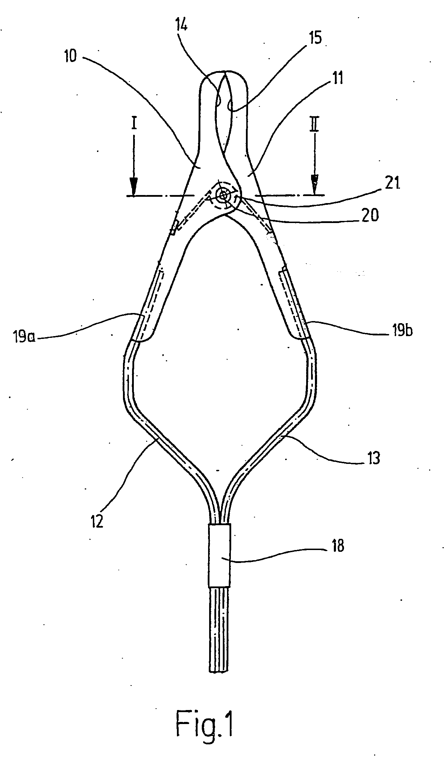

- Figur 1: eine nicht erfindungsgemäß ausgebildete Anschlussklemme.

Figur 1 zeigt eine Anschlussklemme für ein Batterietestgerät, wobei die Anschlussklemme eine erste Klemmenhälfte 10 und eine zweiten Klemmenhälfte 11 aufweist. Die erste Klemmenhälfte 10 und die zweite Klemmenhälfte 11 sind dazu vorgesehen, einen Kontakt in Form eines Batteriepols mit einer ersten Leitung 12 und mit einer zweiten Leitung 13 elektrisch zu verbinden. Dabei bildet die erste Klemmenhälfte 10 einen ersten Kontaktbereich 14, der ausschließlich zur Herstellung der Verbindung zwischen dem Batteriepol und der ersten Leitung 12 vorgesehen ist. In ähnlicher Weise bildet die zweite Klemmenhälfte 11 einen zweiten Kontaktbereich 15, der ausschließlich zur Herstellung der Verbindung zwischen dem Batteriepol und der zweiten Leitung 13 vorgesehen ist. Dabei sind der erste Kontaktbereich 14 und der zweite Kontaktbereich 15 elektrisch voneinander isoliert. Die erste Klemmenhälfte 10 und die zweite Klemmenhälfte 11 sind durch ein Gelenk 20 miteinander verbunden. Die erste Leitung 12 ist dabei zum Anschluss einer Last vorgesehen, die mit Hilfe einer zweiten erfindungsgemäßen Anschlussklemme zwischen den beiden Batteriepolen angeschaltet wird. Die zweite Leitung 13 ist zur Durchführung einer Strom- oder Spannungsmessung vorgesehen, wobei diese Messung mit Hilfe der zweiten erfindungsgemäßen Anschlussklemme zwischen den Batteriepolen durchgeführt wird. Die dargestellte Anschlussklemme weist Vorspannmittel 21 in Form einer Spiralfeder 21 auf, die den ersten Kontaktbereich 14 und den zweiten Kontaktbereich 15 aufeinander zu vorspannt. Im dargestellten Fall sind die erste Leitung 12 und die zweite Leitung 13 erfindungsgemäß hinter der Anschlussklemme durch Verbindungsmittel 18 elektrisch isoliert verbunden. Die Verbindungsmittel 18 sind dabei durch eine über die erste Leitung 12 und die zweite Leitung 13 geschobene Hülse gebildet, die beispielsweise aus Kunststoff hergestellt sein kann. Im weiteren Verlauf, das heißt auf der von der Anschlussklemme abgewandten Seite der Hülse 18, sind die erste Leitung 12 und die zweite Leitung 13 miteinander verbunden, beispielsweise nach Art eines doppeladrigen Kabels. Die erste Leitung 12 ist an dem einen ersten Griff 19a bildenden Endabschnitt der ersten Klemmenhälfte 10 herausgeführt, während die zweite Leitung 13 an dem einen zweiten Griff 19b bildenden Endabschnitt der zweiten Klemmenhälfte 11 herausgeführt ist. Diese Art der Herausführung der ersten Leitung 12. und der zweiten Leitung 13 ermöglicht es in Verbindung mit der Hülse 18, dass die erfindungsgemäße Anschlussklemme beispielsweise durch mehrere andere Kabel herausgezogen werden kann, ohne sich zu verhaken.

## Patentansprüche

1. Anschlussklemmensystem, insbesondere Anschlussklemmensystem für ein Batterietestgerät, mit einer Anschlussklemme, einer ersten Leitung (12) und einer zweiten Leitung (13), wobei die Anschlussklemme eine erste Klemmenhälfte (10) und eine zweite Klemmenhälfte (11) aufweist, die durch ein Gelenk (20) miteinander verbunden sind und die Anschlussklemme dazu vorgesehen ist, einen Kontakt mit der ersten Leitung (12) und mit der zweiten Leitung (13) elektrisch zu verbinden, wobei die erste Klemmenhälfte (10) nur einen ersten Kontaktbereich (14) aufweist, der ausschließlich zur Herstellung der Verbindung zwischen dem Kontakt und der ersten Leitung (12) vorgesehen ist, dass die zweite Klemmenhälfte (11) nur einen zweiten Kontaktbereich (15) aufweist, der ausschließlich zur Herstellung der Verbindung zwischen dem Kontakt und der zweiten Leitung (13) vorgesehen ist, dass der erste Kontaktbereich (14) und der zweite Kontaktbereich (15) elektrisch voneinander isoliert sind und dass die erste Klemmenhälfte (10) zumindest einen aus elektrisch leitfähigem Material hergestellten, den ersten Kontaktbereich (14) bildenden, ersten Abschnitt aufweist, dass die erste Leitung an dem einen ersten Griff (19a) bildenden Endabschnitt der ersten Klemmenhälfte (10) herausgeführt ist, und dass die zweite Leitung (13) an dem einen zweiten Griff (19b) bildenden Endabschnitt der zweiten Klemmenhälfte (11) herausgeführt ist, **dadurch gekennzeichnet, dass** die erste Leitung (12) und die zweite Leitung (13) hinter der Anschlussklemme durch Verbindungsmittel (18) elektrisch isoliert verbunden sind und dass sich der erste Abschnitt nicht bis zu dem Gelenk (20) erstreckt.

2. Anschlussklemmensystem nach Anspruch 1, **dadurch gekennzeichnet, dass** die zweite Klemmenhälfte (11) zumindest einen aus elektrisch leitfähigem Material hergestellten zweiten Abschnitt aufweist, der den zweiten Kontaktbereich (15) bildet.

3. Anschlussklemmensystem nach Anspruch 2, **dadurch gekennzeichnet, dass** sich der zweite Abschnitt nicht bis zu dem. Gelenk (20) erstreckt.

4. Anschlussklemmensystem nach einem der vorhergehenden Ansprüche, **dadurch gekennzeichnet, dass** die Ader der ersten Leitung (12) an einem ersten Verbindungspunkt an den ersten Abschnitt angeschweißt ist, und dass die Ader der zweiten Leitung (13) an einem zweiten Verbindungspunkt an den zweiten Abschnitt angeschweißt ist.

5. Anschlussklemmensystem nach einem der vorhergehenden Ansprüche, **dadurch gekennzeichnet, dass** die erste Leitung (12) zum Anschluss einer Last vorgesehen ist.

6. Anschlussklemmensystem nach einem der vorhergehenden Ansprüche, **dadurch gekennzeichnet, dass** die zweite Leitung (13) zur Durchführung einer Strom- und/oder Spannungsmessung vorgesehen ist.

7. Anschlussklemmensystem nach einem der vorhergehenden Ansprüche, **dadurch gekennzeichnet, dass** Vorspannmittel (21) vorgesehen sind, die den ersten Kontaktbereich (14) und den zweiten Kontaktbereich (15) aufeinander zu vorspannen.

8. Anschlussklemmensystem nach einem der vorhergehenden Ansprüche, **dadurch gekennzeichnet, dass** das Gelenk (20) ein Drehgelenk (20) ist, das einen Bolzen (22) umfasst, um den die erste Klemmenhälfte (10) und/oder die zweite Klemmenhälfte (11) schwenkbar sind.

9. Anschlussklemmensystem nach einem der vorhergehenden Ansprüche, **dadurch gekennzeichnet, dass** die Vorspannmittel (21) im Bereich des Gelenks (20) angeordnet sind.

10. Anschlussklemmensystem nach einem der vorhergehenden Ansprüche, **dadurch gekennzeichnet, dass** die Vorspannmittel (21) durch eine Spiralfeder (21) gebildet sind, die zumindest abschnittsweise um den Bolzen (22) herum angeordnet ist.

11. Anschlussklemmensystem nach einem der vorhergehenden Ansprüche, **dadurch gekennzeichnet, dass** die Vorspannmittel (21) ein erstes freies Ende (25) und ein zweites freies Ende (26) aufweisen, und dass sich das erste freie Ende. (25) an der ersten Klemmenhälfte (10) abstützt, während sich das zweite freie Ende (26) an der zweiten Klemmenhälfte (11) abstützt.

12. Verwendung eines Anschlussklemmensystems nach einem der Ansprüche 1 bis 11 mit einem Batterietestgerät.

## Claims

1. Connection terminal system, in particular connection terminal system for a battery test device, having a connection terminal, a first line (12) and a second line (13), the connection terminal having a first terminal half (10) and a second terminal half (11), which are connected to one another by a joint (20), and the connection terminal being provided for the purpose of electrically connecting a contact to the first line (12) and to the second line (13), the first terminal half (10) having only a first contact region (14), which is provided exclusively for producing the connection between the contact and the first line (12), the second terminal half (11) having only a second contact region (15), which is provided exclusively for producing the connection between the contact and the second line (13), the first contact region (14) and the second contact region (15) being electrically insulated from one another, and the first terminal half (10) having at least one first section, which is produced from electrically conductive material and forms the first contact region (14), the first line being passed out at that end section of the first terminal half (10) which forms a first grip (19a), and the second line (13) being passed out at that end section of the second terminal half (11) which forms a second grip (19b), **characterized in that** the first line (12) and the second line (13) are connected such that they are electrically insulated from one another behind the connection terminal by means of connection means (18), and **in that** the first section does not extend up to the joint (20).

2. Connection terminal system according to Claim 1, **characterized in that** the second terminal half (11) has at least one second section, which is produced from electrically conductive material and forms the second contact region (15).

3. Connection terminal system according to Claim 2, **characterized in that** the second section does not extend up to the joint (20).

4. Connection terminal system according to one of the preceding claims, **characterized in that** the core of the first line (12) is welded to the first section at a first connection point, and **in that** the core of the second line (13) is welded to the second section at a second connection point.

5. Connection terminal system according to one of the preceding claims, **characterized in that** the first line (12) is provided for connecting a load.

6. Connection terminal system according to one of the preceding claims, **characterized in that** the second line (13) is provided for carrying out a current and/or voltage measurement.

7. Connection terminal system according to one of the preceding claims, **characterized in that** pretensioning means (21) are provided which pretension the first contact region (14) and the second contact region (15) with respect to one another.

8. Connection terminal system according to one of the preceding claims, **characterized in that** the joint (20) is a swivel joint (20), which comprises a bolt (22), about which the first terminal half (10) and/or the second terminal half (11) can be pivoted.

9. Connection terminal system according to one of the preceding claims, **characterized in that** the pretensioning means (21) are arranged in the region of the joint (20).

10. Connection terminal system according to one of the preceding claims, **characterized in that** the pretensioning means (21) are formed by a helical spring (21), which is arranged, at least in sections, around the bolt (22).

11. Connection terminal system according to one of the preceding claims, **characterized in that** the pretensioning means (21) have a first free end (25) and a second free end (26), and **in that** the first free end (25) is supported on the first terminal half (10), while the second free end (26) is supported on the second terminal half (11).

12. Use of a connection terminal system according to one of Claims 1 to 11 with a battery test device.

## Revendications

1. Système de pince de raccordement notamment pour un testeur de batterie comportant une pince de raccordement, une première ligne (12) et une seconde ligne (13), dans lequel
la pince de raccordement avec une première moitié de pince (10) et une seconde moitié de pince (11) reliées l'une à l'autre par une articulation (20) est destinée à relier électriquement un contact avec la première ligne (12) et avec la seconde ligne (13),
la première moitié de pince (10) ne comporte qu'une première zone de contact (14) destinée exclusivement à réaliser la liaison entre le contact et la première ligne (12), et la seconde moitié de pince (11) n'a qu'une seconde zone de contact (15) destinée exclusivement à réaliser la liaison entre le contact et la seconde ligne (13), la première zone de contact (14) et la seconde zone de contact (15) étant isolées électriquement l'une de l'autre, et
la première moitié de pince (10) a au moins un premier segment en une matière électro-conductrice constituant la première zone de contact (14), la première ligne sortant du segment d'extrémité de la première moitié de pince (10) qui forme une première poignée (19a), alors que la seconde ligne (13) sort du segment d'extrémité de la seconde moitié de pince (11) constituant une seconde poignée (19b),
**caractérisé en ce que**
la première ligne (12) et la seconde ligne (13) sont reliées de manière isolée électriquement derrière la pince de raccordement par des moyens de liaison (18), et
le premier segment ne s'étend pas jusqu'à l'articulation (20).

2. Système de pince de raccordement selon la revendication 1,
**caractérisé en ce que**
la seconde moitié de pince (11) comporte au moins un segment en une matière électro-conductrice qui forme la seconde zone de contact (15).

3. Système de pince de raccordement selon la revendication 2,
**caractérisé en ce que**
le second segment n'atteint pas l'articulation (20).

4. Système de pince de raccordement selon l'une des revendications précédentes,
**caractérisé en ce que**
les brins de la première ligne (12) sont soudés à un premier point de liaison du premier segment et les brins de la seconde ligne (13) sont soudés à un second point de liaison du second segment.

5. Système de pince de raccordement selon l'une des revendications précédentes,
**caractérisé en ce que**
la première ligne (12) est destinée au branchement d'une charge.

6. Système de pince de raccordement selon l'une quelconque des revendications précédentes,
**caractérisé en ce que**
la seconde ligne (13) est prévue pour effectuer une mesure d'intensité et/ ou de tension.

7. Système de pince de raccordement selon l'une des revendications précédentes,
**caractérisé par**
des moyens de précontrainte (21) qui assurent la précontrainte de la première zone de contact (14) et de la seconde zone de contact (15) l'une vers l'autre.

8. Système de pince de raccordement selon l'une des revendications précédentes,
**caractérisé en ce que**
l'articulation (20) est une articulation de pivotement (20) comportant un goujon (22) autour duquel la première moitié de pince (10) et/ou la seconde moitié de pince (11) peuvent pivoter.

9. Système de pince de raccordement selon l'une quelconque des revendications précédentes,
**caractérisé en ce que**
les moyens de précontrainte (21) sont installés au niveau de l'articulation (20).

10. Système de pince de raccordement selon l'une des revendications précédentes,
**caractérisé en ce que**
les moyens de précontrainte (21) sont formés par un ressort spiral (21 qui entoure au moins par segment le goujon (22).

11. Système de pince de raccordement selon l'une quelconque des revendications précédentes,
**caractérisé en ce que**
les moyens de précontrainte (21) comportent une première extrémité libre (25) et une seconde extrémité libre (26) et la première extrémité libre (25) s'appuie contre la première moitié de pince (10) alors que la seconde extrémité libre (26) s'appuie contre la seconde moitié de pince (11).

12. Application d'un système de pince de raccordement selon l'une des revendications 1 à 11 à un appareil de test de batterie.
